# EUROPEAN PATENT SPECIFICATION

(11) **EP 2 833 403 B1**
(45) Date of publication and mention of the grant of the patent: **24.05.2017**
(21) Application number: 14178071.8
(22) Date of filing: 22.07.2014
(51) Int. Cl.: H01L 23/473, F28D 15/00, H05K 7/20

(54) **Header for electronic cooler**
Kopfelement für elektronischen Kühler
Collecteur pour refroidisseur électronique

(30) Priority: 01.08.2013 US 201313956420
(43) Date of publication of application: 04.02.2015
(73) Proprietor: Hamilton Sundstrand Corporation, Charlotte, NC 28217 (US)
(72) Inventor: Himmelmann, Richard A., Beloit, WI Wisconsin 53511 (US); Turney, Joseph, Amston, CT Connecticut 06231 (US)
(74) Representative: Leckey, David Herbert

(56) References cited:
- US-A- 5 016 707
- US-A- 5 737 186
- US-A1- 2004 206 477
- US-A1- 2007 119 565
- US-A1- 2008 264 604
- US-A1- 2009 283 244
- US-A1- 2011 048 689
- US-A1- 2012 012 299

## Description

### BACKGROUND

This application relates to a header for supplying cooling fluid to electronic components and for returning the cooling fluid.

Electronics are becoming utilized in more and more applications. The size of the electronic components is continuously being reduced. There are now any number of electronic chips that are sized one millimeter by one millimeter, and even smaller.

As the applications controlled and performed by the electronics have increased, the heat generated by the electronics has also increased. The historic ways of dissipating heat, such as heat fins, may no longer always be adequate. Thus, it becomes important to provide cooling fluid in an efficient manner to the very small electronic components.

In addition, the electronics are being packed in plural arrays. The cooling fluid must be provided to the several electronics components in an efficient manner.

US 2011/048689 A1 refers to microchannel heat sink cooling systems.

US 2009/283244 A1 refers to coolers for integrated circuit chips, and more particularly to stacked and redundant coolers.

US 2008/264604 A1 refers to heat transfer mechanisms, and more particularly, to cooling apparatuses , cooled electronic modules and methods of fabrication thereof for removing heat generated by one or more electronic devices.

### SUMMARY

A fluid cooler packet for a plurality of electronic components has a plurality of individual cooling circuits for receiving a supply of cooling fluid from a supply header and delivering that cooling fluid to an associated electronic component. The plurality of cooling circuits each includes a return passage for receiving a return fluid after having cooled the associated electronic component, and returns the return fluid to a return header. A volume of the supply header decreases in a downstream direction as it passes over the plurality of individual cooling circuits. A volume of the return header increases as it moves in a downstream direction over the plurality of individual cooling circuits. An electronic component array is also disclosed.

These and other features may be best understood from the following drawings and specification.

### BRIEF DESCRIPTION OF THE DRAWINGS

Figure 1 shows an electronic component.
Figure 2A shows an array including a plurality of the Figure 1 components.
Figure 2B shows a cooling circuit for cooling one of the electronic components within the array of Figure 2A.
Figure 2C shows a detail of one layer.
Figure 2D shows a detail of another layer.
Figure 2E shows a sandwich assembly of layers shown in Figure 2B.
Figure 3A shows the overall flow passage associated with one cooling circuit.
Figure 3B shows a portion of the flow path.
Figure 3C shows another portion of the flow path.
Figure 4 shows a header for communicating all of the separate cooling circuits together.
Figure 5A shows an alternative header.
Figure 5B shows a detail of the Figure 5A header.
Figure 5C shows a benefit of the Figure 5A header.
Figure 5D shows another embodiment.

### DETAILED DESCRIPTION

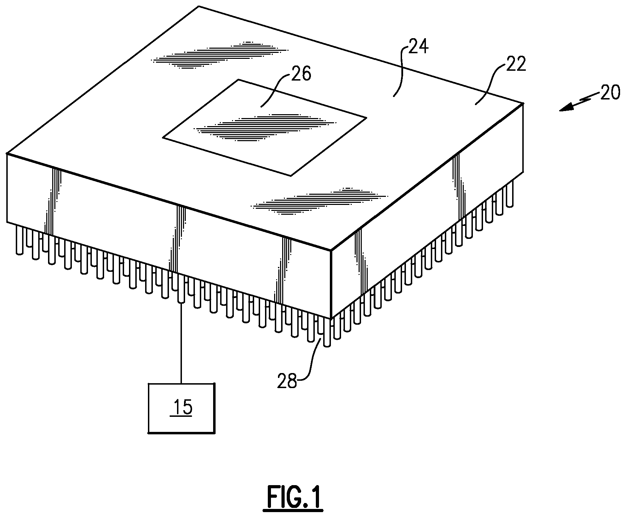

Figure 1 shows an electronic assembly 20. The assembly includes an electronic component 22 that may be extremely small and on the order of one millimeter by one millimeter as an example. Of course, this size is merely an example.

The electronic component 22 may be a computer chip or other electronic element. The component is shown schematically controlling a system 15. The electronic component 22 is shown schematically connected to system 15 by connector pins 28. An area 26 may generate more heat than an area 24.

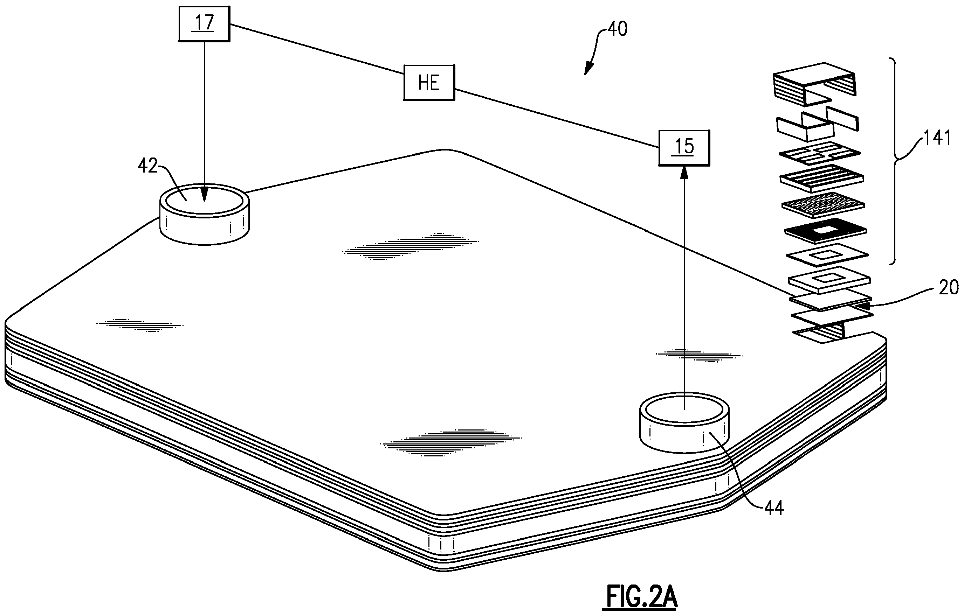

Thus, Figure 2A shows an array 40 that provides a fluid cooler packet. The array 40 incorporates and cools a large number of the assemblies 20, such as shown in Figure 1. In one embodiment, there may be a 10 by 10 array of the Figure 1 assemblies 20 within the array 40. Of course, other numbers would come within the scope of this disclosure.

A supply port 42 and a discharge or return port 44 are shown. A cooling packet or circuit 141 associated with one of the assemblies 20 is shown in an exploded view. As shown, a supply 17 supplies cooling fluid into the supply port 42, and a downstream destination 15 receives return fluid from the return port 44. As shown schematically, a heat exchanger HE may be between the destination 15, and source 17 such that the cooling fluid is recirculated in a closed loop.

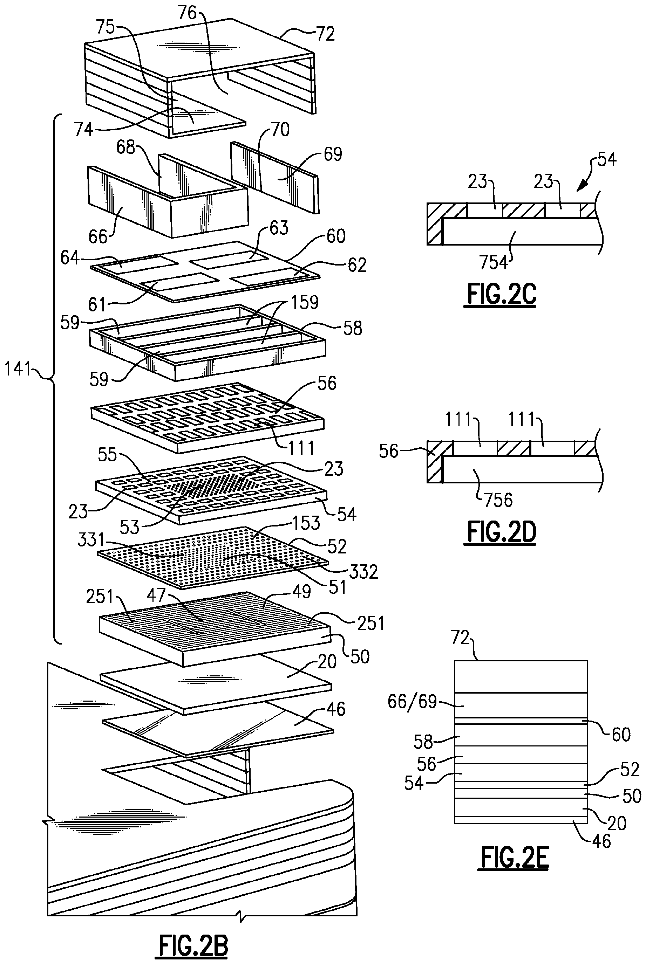

As shown in Figure 2B, a silicone layer 46 is positioned adjacent the assembly 20.

An impingement channel layer 50 has a plurality of channels 251 extending generally parallel to each other.

As can be seen, the layer 50 has a higher density central area 47, with a higher density of channels 251, and a lower density outer area 49 with a lower density of channels 251. The lower density area 49 is associated with cooling the area 24 of component 22 while the area 47 is positioned to cool the higher heat area 26.

An orifice layer 52 includes a plurality of holes 51 in a higher density area 331, and other holes 153 in a lower density area 332.

A small slot layer 54 provides a number of supply and return slots 23 and has area 53 with a high density of slots 23 and area 55 of a lower density of slots 23. As can be appreciated, these areas are also associated with the area 26 and the area 24 on component 22, respectively.

As shown somewhat schematically in Figure 2C, the small slot layer 54 has a channel 754 which communicates with a plurality of the slots 23 in the upper surface. It should be understood that spaced into the plane of this Figure, there would be other channels, which are maintained separate from channel 754, and alternate ones of the channels provide supply and return flow passages, as will be better described below.

A large slot layer 56 has slots 111 that communicate the slots 23 in the small slot layer 54 into a plurality of channels 59 in an outer channel layer 58. A porting layer 60 has openings 61, 62, 63 and 64. As can be seen, an opening 64 is associated with one channel 59. Ribs 159 within the layer 58 separate the channels 59, such that other openings 61, 63 and 64 are each associated with distinct channels 59.

As shown schematically in Figure 2D, the slots 111 communicate with an elongated channel 756. Again, separate channels would be spaced into the plane of this Figure, and would also provide separate supply and return passages. In general, the slots and channels of the layer 54 and layer 56 extend perpendicular to each other.

A separator layer 66/69 has walls which will separate the flow from the openings 61 and 64 into a channel or passage 68 and the flow from ports 62 and 63 into a channel or passage 70. A header portion 72 has a closure wall 74 blocking flow from the channel 68 into a passage 76, but allowing flow from the channel 70 into the passage 76. Downstream of the header 72, there will be another header, which provides the reverse structure, and will communicate the channel 68 into another passage similar to passage 76.

As can be appreciated from Figure 2B, a portion of the passage 76 communicates with a space 75 that would be above the wall 74, and channel or passage 68. As will be disclosed below, with regard to the overall header, this provides a "nested" arrangement for the header which more efficiently uses the overall space.

Figure 2E shows the assembly of the various layers on to the assembly 20. If the channel 68 is a supply channel and the channel 70 is a return channel, then fluid would be supplied into the channel 68, pass through the opening 64 and 61 into channels 59 in the layer 58, and then through associated slots 111 in the layer 56, through slots 23 in the layer 54, holes 51/153 in layer 52, and into a channel 251 in layer 50.

The flow downstream of the orifices 51/153 in the layer 52 then impacts upon the electronic component 20 cooling it. The fluid passes along the channel 251 until moving back outwardly through other holes 51/153 in the orifice layer 54 that may be associated with slots 23 in the small slot layer 54, and associated with a slot 111 moving into a channels 159 that is associated with a return passage.

The fluid then passes through an opening 62/63 in porting layer 60 and into passage 76.

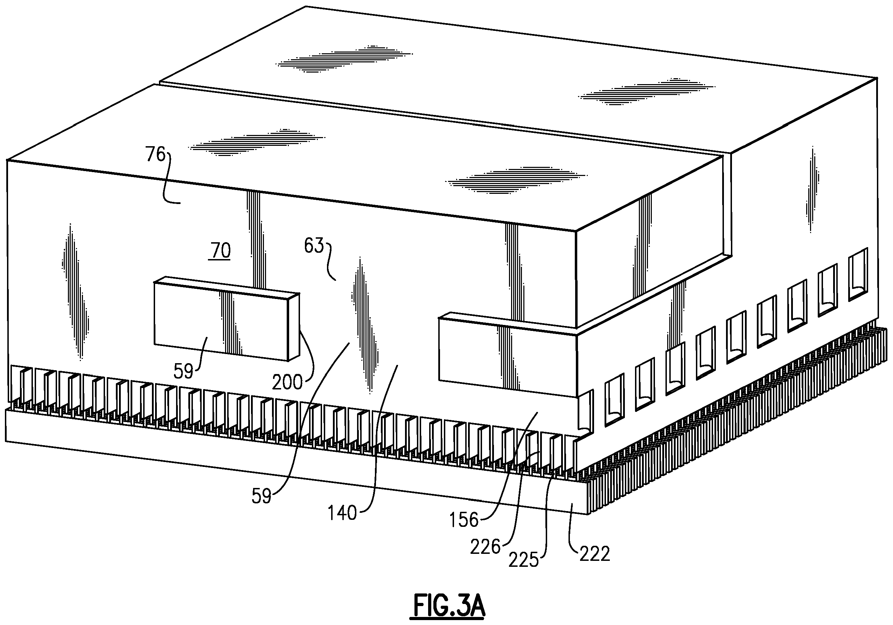

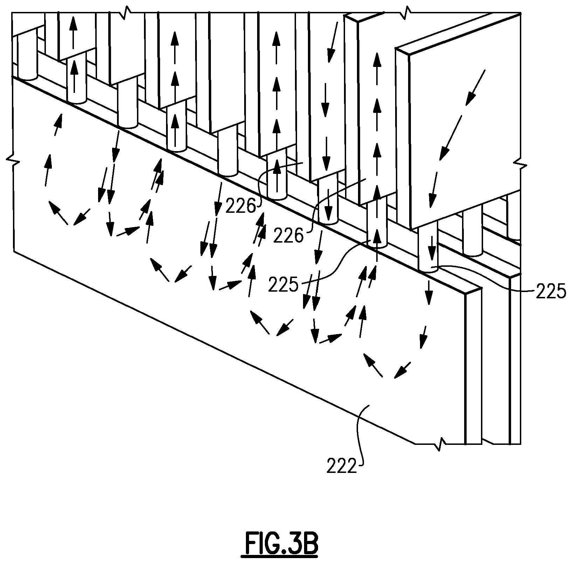

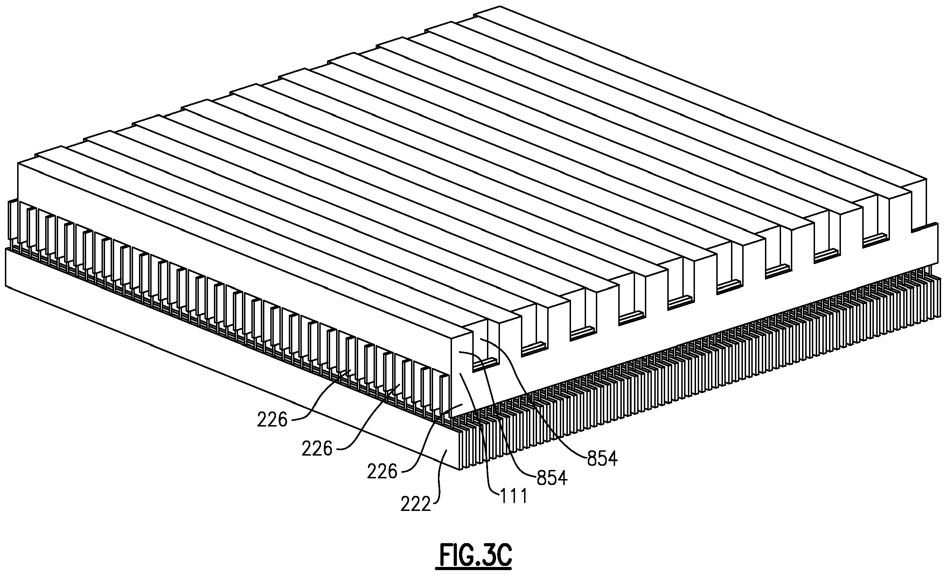

Figure 3A shows the spaces within the layers of Figures 2B and 2C, rather than the structure of the layers. Figure 3 is a "reverse" model from the structure illustrated in the earlier figures and shows the shape and size of the flow passages, rather than the structure that forms the flow passages. The lines separating areas in Figure 3 would actually include structure, such as the walls and the layers as shown in the earlier figures.

Figure 3A shows the combination of the channel 70 and passage 76 communicating with an opening 63 to in turn communicate with a channel 59. Another channel 59 is shown as being separated by a line 200. As mentioned above, the line 200 will actually be a structural wall in the cooling circuit as formed.

An area 140 would be an opening into one of the slots 111, and a portion 156 would be formed by the slots 111 within the body of the layer 56. Portions 226 are formed by the slots in the small slot layer 54. Pins 225 are formed by the holes in the orifice layer 52. The portions 222 are the actual impingement channels 51 within the impingement channel layer 50.

To this point, the disclosure has focused largely on cooling a single assembly 20. However, as mentioned above, the overall array of embodiment 40 may include a plurality of such assemblies.

Figure 3B shows the impingement of the fluid coming through one orifice 225 into an impingement channel 222. Figure 3B is also a "reverse" model showing the flow passages rather than structure. This flow then impacts upon the component to be cooled, flows along a channel, and then moves upwardly through an adjacent orifice 225 and communicates back through a return passage 226, which may be defined by the channel 754 in the small slot layer 54.

Figure 3C shows the adjacent passages 226 formed by the channels 756 communicating through slots 111 to passages 854 which are formed by the channels 754 in the large slot layer 54. The slots 111 will then communicate these passages 754 along supply and return paths, as can be appreciated. Figure 3C is also a "reverse" model.

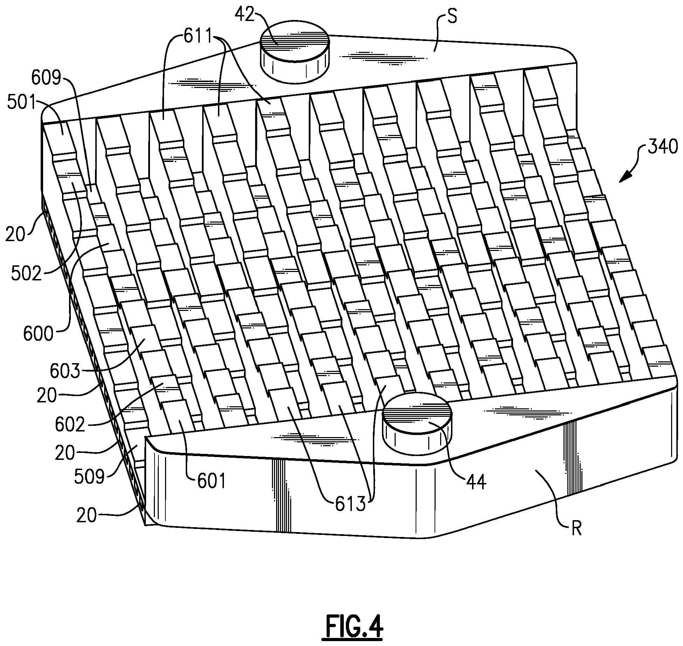

Figure 4 shows a header structure for the array 40. As shown in Figure 4, a supply header S and a return header R are positioned at opposed ends of an array 340. This is not the "nested" embodiment as mentioned above with regard to Figure 2B, but rather an alternative.

Any other number of other arrangements can be utilized to communicate between the header and the component to be cooled.

There would be a greater amount of supply fluid at an upstream end of the supply port 42, and a smaller amount of return fluid at that most upstream point. As the supply header moves toward a downstream end, the volume of the supply fluid would decrease, while the volume of return fluid would increase. Thus, in embodiment 340, there is a "stepped" sizing to the headers, such that the return header has a smallest volume point 609, increasing through point 600, 603, 602, and eventually to point 601 which is relatively high.

On the other hand, the supply header has a highest volume 501 decreasing through steps 502, and eventually reaching a smallest point 509. By sizing the header flow volumes to increase or decrease as the volume could be handled by also increases or decreases, this header embodiment 340 will ensure that the pressure is maintained as desired along the entire flow path.

There are also a plurality of parallel supply header portions 611 and parallel return header portions 613. The supply header portions 611 decrease in size, and hence volume, in a downstream direction moving from the supply port 42 toward the return port 44. As illustrated there are a plurality of assemblies 20 associated with each of the steps, such that the parallel supply header portions 611 decrease in a stepped manner with each assembly 20 moving in a downstream direction. Similarly, the return header steps increase along each of the parallel return header portions 613. In one embodiment, the array 340 is a 10 x 10 array cooling 100 electronic components 22. Each step along each of the parallel supply and return header portions 611 and 613 would change by 10% from the prior step.

Of course, if there were a number other than 10 of the steps, the change would not be 10%. However, in some embodiments, the change is generally equal for each step. As an example, if there were four steps, the change might be 25% on each step, in one embodiment.

It could be said that the assemblies 20 are formed into columns and rows, with the rows each being associated with one of the parallel supply header portions 611, and one of the parallel return header portions 613. Each step along each of the portions 611/613 is associated with one of the columns across the rows.

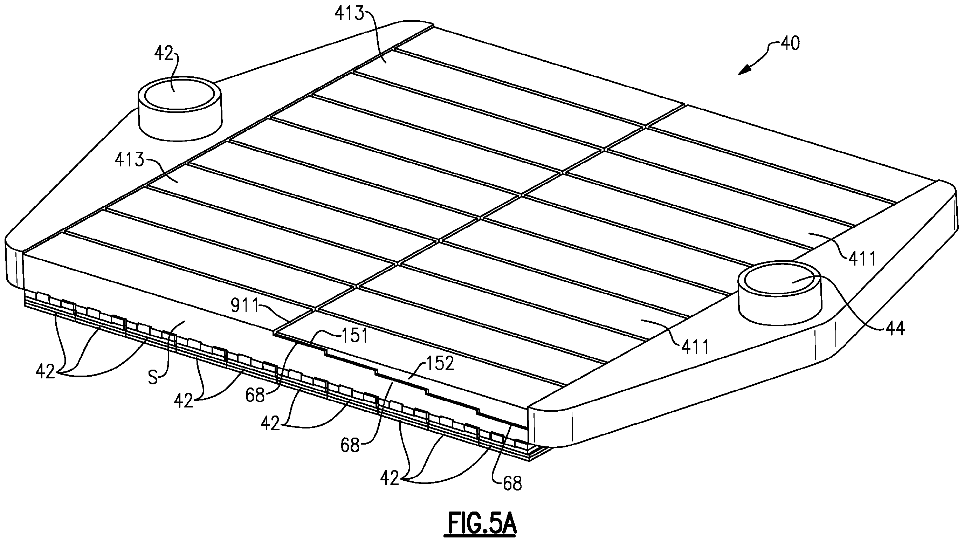

Figure 5A shows a header embodiment 140. Header embodiment 140 more efficiently utilizes a space (see 75 in Figure 2B, as an example) which is above the steps of the header embodiment 340, and results in a more compact overall array 40. This nested embodiment is what is illustrated in Figure 2B. As can be appreciated, the supply header S has its portions shown to the bottom right hand side of Figure 5A which actually communicate the cooling fluid and decrease in size as shown at 68. These are also nested return header portions 151, 152, etc. above the supply header portions.

Thus, the unused space beyond the stepped header portions of the Figure 4 embodiment 340 are now utilized to provide some of the flow volume.

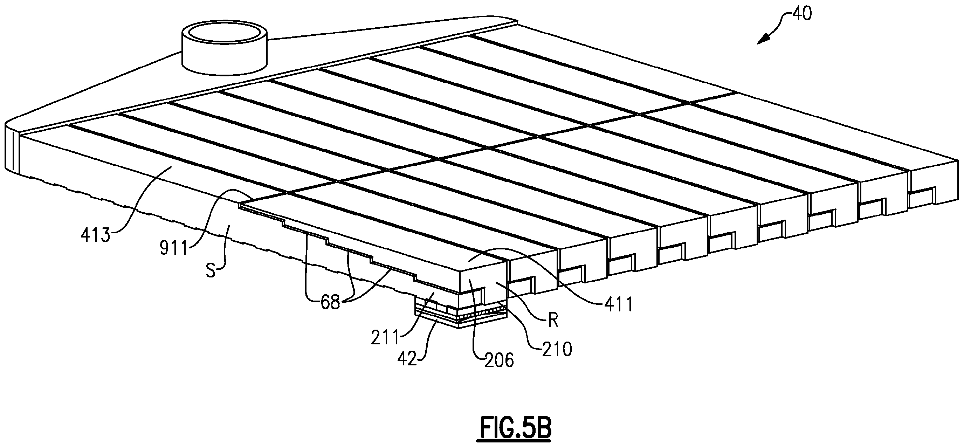

As seen in Figure 5B, which is again a reverse model, the supply header communicates to cool an assembly through a cooling circuit and as shown at 211. There are decreasing channel steps 68, which are provided by the structure shown at 142, 146, 147, etc. in Figure 5A. However, there is a nested portion 206 of the return header R which extends outwardly, or on a reverse face of supply headers facing away from the component and cooling circuits 42. This nested portion is formed for example by the area or space 75 as shown in Figure 2B. A portion 210 of the return header R also communicates with a cooling circuit 42, and would for example be the channel 76 as shown in Figure 2B.

Again, there would be associated rows and columns, and associated parallel supply header portions 413, and associated parallel return header portions 411.

As shown in Figures 5A and 5B, there is a breakpoint 911 between an upper surface of the supply header portions 413, and an upper surface of the return header portions 411. In the first half of the "steps," there would be a nested portion on the supply header above the return header. In a second half, the nested portion are as illustrated in Figures 5A and 5B, as being part of the return header, and being outwardly of the supply header step portions. This switch in the headers that have the nested portion is necessary, as the nested portion must be able to communicate with the portion actually supplying the fluid to the components in the supply header, and able to communicate back into the return header from those components. Thus, it is only some of the plurality of cooling circuits which have the nested portions on the return header and the nested portions on the supply header.

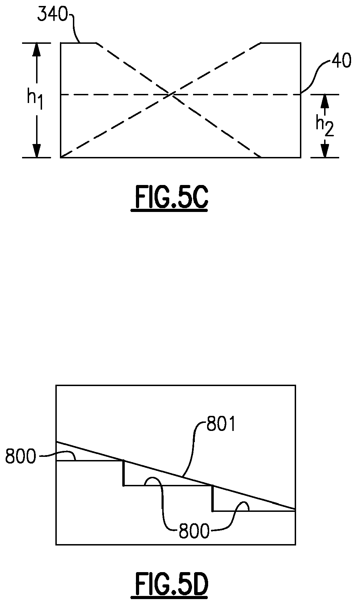

With the embodiment 40 as illustrated in Figures 5A and 5B, there is a reduction in height as is illustrated in Figure 5C. The embodiment 340 would require a height h₁ due to the unused space. The embodiment 40 however would have a much smaller height h₂, while maintaining the same flow vs pressure drop performance, due to the nested combination.

The header embodiments illustrated in this invention provide improved pressure regulation along the path of both the supply and return fluids. It should be understood that all of the flow passages illustrated in this disclosure can be formed by silicon layering techniques.

Further, while the increase and decrease in the headers is shown in a step fashion, in embodiments, they may generally be more ramped, and formed along a single slope. Thus, as shown in Figure 5D, rather than the steps shown at 800, one embodiment would actually extend along a slope shown at 801.

## Claims

1. A fluid cooler packet (141) for a plurality of electronic components (22) comprising:
a plurality of individual cooling circuits for receiving a supply of cooling fluid from a supply header (S) and delivering that cooling fluid to an associated electronic component (22), said plurality of cooling circuits each including a return passage for receiving a return fluid after having cooled the associated electronic component (22), and returning the return fluid to a return header (R); and
a volume of the supply header (S) decreasing in a downstream direction as it passes over the plurality of individual cooling circuits, and a volume of the return header (R) increasing as it moves in a downstream direction over the plurality of individual cooling circuits, wherein said plurality of individual cooling circuits are assembled in an array of rows and columns, and there are a plurality of parallel supply header portions (611;413) associated with each of said rows, and a plurality of parallel return header portions (613;411) associated with each of said rows, with a downstream direction being defined across said plurality of columns, and **characterized in that**
said parallel supply header portions have nested portions which are positioned outwardly of a face of said parallel return header portions spaced away from at least some of the individual cooling circuits, with a volume of said nested portions of said parallel supply header portions decreasing as said volume of said return header parallel portions increases in a downstream direction, and said parallel return header portions have nested portions which are positioned outwardly of a face of said parallel supply header portions spaced away from at least some of the individual cooling circuits, with a volume of said nested portions of said parallel return header portions increasing as said volume of said supply header parallel portions decreases in a downstream direction.

2. The packet as set forth in claim 1, wherein said plurality of parallel supply header portions (611;413) decrease in steps across each of said plurality of individual cooling circuits, and said plurality of parallel return header portions (613;411) increasing in steps across each of said plurality of individual cooling circuits.

3. The packet as set forth in claim 2, wherein a supply port (42) communicates with said supply header (S) at one end of said fluid cooler, and a return port positioned at an opposed end relative to the supply port communicates with said return header (R).

4. The packet as set forth in any of claims 1 to 3, wherein said return header (R) has a nested portion associated with a face of said supply header facing away from at least some of the plurality of cooling circuits, and said nested portion of said return header increasing in volume as the volume of said supply header decreases in a downstream direction, and said supply header having a nested portion outwardly of a face of said return header facing away from at least some of the plurality of individual cooling circuits, with said nested portion of said supply header decreasing in volume as said return header increases in volume along a downstream direction.

5. The packet as set forth in claims 3, 4 or 5, wherein walls isolate said nested portions, with said walls being outwardly of return and supply channel portions to separate return and supply fluid flows.

6. The packet as set forth in any preceding claim, wherein the individual cooling circuits include an impingement channel layer (50) for directing fluid against an electronic component, and communicating that fluid back through into said return header (R).

7. The packet as set forth in claim 6, wherein an orifice layer (52) is positioned outwardly of the impingement channel layer (50), with said orifice layer (52) having a plurality of holes (51), with sets of said holes communicating with a return channel portion, and other of said holes (51) communicating with a supply channel portion, with said return and supply channels communicating back into said return and supply headers (R,S), respectively.

8. An electronic component array comprising:
a plurality of electronic components; and
a fluid cooler packet as set forth in any preceding claim, each individual cooling circuit delivering cooling fluid to an associated one of said plurality of electronic components.

## Patentansprüche

1. Fluidkühlerpaket (141) für eine Vielzahl elektronischer Bauelemente (22), umfassend:
eine Vielzahl einzelner Kühlkreisläufe zum Empfangen einer Zufuhr an Kühlfluid von einem Zufuhrkopfelement (S) und zum Fördern dieses Kühlfluids zu einem verbundenen elektronischen Bauelement (22), wobei die Vielzahl von Kühlkreisläufen jeweils einen Rückführdurchlass zum Empfangen eines Rückführfluids, nachdem es das verbundene elektronische Bauelement (22) gekühlt hat, und Rückführen des Rückführfluids zu einem Rückführkopfelement (R) umfasst; und
ein Volumen des Zufuhrkopfelementes (S), das in einer Stromabwärtsrichtung abnimmt, wenn es über die Vielzahl einzelner Kühlkreisläufe passiert, und ein Volumen des Rückführkopfelementes (R), das zunimmt, wenn es sich in einer Stromabwärtsrichtung über die Vielzahl einzelner Kühlkreisläufe bewegt, wobei die Vielzahl einzelner Kühlkreisläufe in einer Anordnung von Reihen und Spalten zusammengesetzt ist, und eine Vielzahl paralleler Zufuhrkopfelementabschnitte (611; 413), die mit jeder der Spalten verbunden ist, und eine Vielzahl von parallelen Rückführkopfelementabschnitten (613; 411), die mit jeder der Spalten verbunden ist, vorliegen, wobei eine Stromabwärtsrichtung über die Vielzahl von Spalten hinweg definiert ist, und **dadurch gekennzeichnet, dass**
die parallelen Zufuhrkopfelementabschnitte verschachtelte Abschnitte aufweisen, die äußerlich einer Seite der parallelen Rückführkopfelementabschnitte angeordnet sind, die von wenigstens einigen der einzelnen Kühlkreisläufe beabstandet sind, wobei ein Volumen der verschachtelten Abschnitte der parallelen Zufuhrkopfelementabschnitte abnimmt, wenn das Volumen der Rückführkopfelementparallelabschnitte in einer Stromabwärtsrichtung zunimmt, und die parallelen Rückführkopfelementabschnitte verschachtelte Abschnitte aufweisen, die äußerlich einer Seite der parallelen Zufuhrkopfelementabschnitte angeordnet sind, die von wenigstens einigen der einzelnen Kühlkreisläufe beabstandet sind, wobei ein Volumen der verschachtelten Abschnitte der parallelen Rückführkopfelementabschnitte zunimmt, wenn das Volumen der Zufuhrkopfelementparallelabschnitte in einer Stromabwärtsrichtung abnimmt.

2. Paket nach Anspruch 1, wobei die Vielzahl paralleler Zufuhrkopfelementabschnitte (611; 413) über jeden von der Vielzahl einzelner Kühlkreisläufe stufenweise weniger wird, und die Vielzahl paralleler Rückführkopfelementabschnitte (613; 411) über jeden von der Vielzahl einzelner Kühlkreisläufe mehr wird.

3. Paket nach Anspruch 2, wobei ein Zufuhranschluss (42) mit dem Zufuhrkopfelement (S) an einem Ende des Fluidkühlers kommuniziert, und ein Rückführanschluss, der an einem entgegengesetzten Ende im Verhältnis zu dem Zufuhranschluss angeordnet ist, mit dem Rückführkopfelement (R) kommuniziert.

4. Paket nach einem der Ansprüche 1 bis 3, wobei das Rückführkopfelement (R) einen verschachtelten Abschnitt aufweist, der mit einer Seite des Zufuhrkopfelementes, die von wenigstens einigen von der Vielzahl von Kühlkreisläufen weg zeigt, verbunden ist, und das Volumen des verschachtelten Abschnittes des Rückführkopfelementes zunimmt, wenn das Volumen des Zufuhrkopfelementes in einer Stromabwärtsrichtung abnimmt, und das Zufuhrkopfelement einen verschachtelten Abschnitt äußerlich einer Seite des Rückführkopfelementes, die von wenigstens einigen von der Vielzahl einzelner Kühlkreisläufe weg zeigt, aufweist, wobei das Volumen des verschachtelten Abschnittes des Zufuhrkopfelementes abnimmt, wenn das Volumen des Rückführkopfelementes entlang einer Stromabwärtsrichtung zunimmt.

5. Paket nach den Ansprüchen 3, 4 oder 5, wobei Wände die verschachtelten Abschnitte isolieren, wobei sich die Wände äußerlich von Rückführ- und Zufuhrkanalabschnitten befinden, um Rückführ- und Zufuhrfluidströme zu trennen.

6. Paket nach einem der vorausgehenden Ansprüche, wobei die einzelnen Kühlkreisläufe eine Prallkanalschicht (50) zum Lenken von Fluid gegen ein elektronisches Bauelement und Durchleiten des Fluids zurück in das Rückführkopfelement (R) umfassen.

7. Paket nach Anspruch 6, wobei eine Austrittschicht (52) äußerlich der Prallkanalschicht (50) angeordnet ist, wobei die Austrittschicht (52) eine Vielzahl von Löchern (51) aufweist, wobei Sätze der Löcher mit einem Rückführkanalabschnitt kommunizieren, und andere von den Löchern (51) mit einem Zufuhrkanalabschnitt kommunizieren, wobei der Rückführ- und Zufuhrkanal in das Rückführ- bzw. Zufuhrkopfelement (R, S) zurück kommunizieren.

8. Anordnung elektronischer Bauelemente, umfassend:
eine Vielzahl elektronischer Bauelemente; und
ein Fluidkühlerpaket nach einem der vorausgehenden Ansprüche, wobei jeder einzelne Kühlkreislauf Kühlfluid zu einem verbundenen von der Vielzahl elektronischer Bauelemente fördert.

## Revendications

1. Paquet refroidisseur de fluide (141) pour une pluralité de composants électroniques (22) comprenant :
une pluralité de circuits de refroidissement individuels destinés à recevoir une alimentation en fluide de refroidissement d'un surmontoir d'alimentation (S) et délivrant ce fluide de refroidissement à un composant électronique associé (22), ladite pluralité de circuits de refroidissement incluant chacun un passage de renvoi destiné à recevoir un fluide de renvoi après avoir refroidi le composant électronique associé (22), et renvoyant le fluide de renvoi à un surmontoir de renvoi (R) ; et
un volume du surmontoir d'alimentation (S) diminuant dans une direction aval à mesure qu'il passe sur la pluralité de circuits de refroidissement individuels, et un volume du surmontoir de renvoi (R) augmentant à mesure qu'il se déplace dans une direction aval sur la pluralité de circuits de refroidissement individuels, dans lequel ladite pluralité de circuits de refroidissement individuels sont assemblés dans un réseau de lignes et de colonnes, et il existe une pluralité de portions de surmontoir d'alimentation parallèles (611 ; 413) associées à chacune desdites lignes, et une pluralité de portions de surmontoir de renvoi parallèles (613 ; 411) associées à chacune desdites lignes, une direction aval étant définie à travers ladite pluralité de colonnes, et **caractérisé en ce que**
lesdites portions de surmontoir d'alimentation parallèles ont des portions imbriquées qui sont positionnées vers l'extérieur d'une face desdites portions de surmontoir de renvoi parallèles à l'écart d'au moins certains des circuits de refroidissement individuels, avec un volume desdites portions imbriquées desdites portions de surmontoir d'alimentation parallèles diminuant à mesure que ledit volume desdites portions parallèles de surmontoir de renvoi augmente dans une direction aval, et lesdites portions de surmontoir de renvoi parallèles ont des portions imbriquées qui sont positionnées vers l'extérieur d'une face desdites portions de surmontoir d'alimentation parallèles à l'écart d'au moins certains des circuits de refroidissement individuels, avec un volume desdites portions imbriquées desdites portions de surmontoir de renvoi parallèles augmentant à mesure que ledit volume desdites portions parallèles de surmontoir d'alimentation diminue dans une direction aval.

2. Paquet selon la revendication 1, dans lequel ladite pluralité de portions de surmontoir d'alimentation parallèles (611 ; 413) diminuent par paliers à travers chacun de ladite pluralité de circuits de refroidissement individuels, et ladite pluralité de portions de surmontoir de renvoi parallèles (613 ; 411) augmentant par paliers à travers chacun de ladite pluralité de circuits de refroidissement individuels.

3. Paquet selon la revendication 2, dans lequel une lumière d'alimentation (42) communique avec ledit surmontoir d'alimentation (S) à une extrémité dudit refroidisseur de fluide, et une lumière de renvoi positionnée à une extrémité opposée par rapport à la lumière d'alimentation communique avec ledit surmontoir de renvoi (R).

4. Paquet selon l'une quelconque des revendications 1 à 3, dans lequel ledit surmontoir de renvoi (R) a une portion imbriquée associée à une face dudit surmontoir d'alimentation en regard à distance d'au moins certains de la pluralité de circuits de refroidissement, et ladite portion imbriquée dudit surmontoir de renvoi augmentant en volume à mesure que le volume dudit surmontoir d'alimentation diminue dans une direction aval, et ledit surmontoir d'alimentation ayant une portion imbriquée vers l'extérieur d'une face dudit surmontoir de renvoi en regard à distance d'au moins certains de la pluralité de circuits de refroidissement individuels, avec ladite portion imbriquée dudit surmontoir d'alimentation diminuant en volume à mesure que ledit surmontoir de renvoi augmente en volume le long d'une direction aval.

5. Paquet selon les revendications 3, 4 ou 5, dans lequel des parois isolent lesdites portions imbriquées, avec lesdites parois vers l'extérieur de portions de canal de renvoi et d'alimentation pour séparer des écoulements de fluide de renvoi et d'alimentation.

6. Paquet selon une quelconque revendication précédente, dans lequel les circuits de refroidissement individuels incluent une couche de canal d'empiétement (50) destinée à diriger un fluide contre un composant électronique, et re-communiquant ce fluide dans ledit surmontoir de renvoi (R).

7. Paquet selon la revendication 6, dans lequel une couche d'orifice (52) est positionnée vers l'extérieur de la couche de canal d'empiétement (50), ladite couche d'orifice (52) ayant une pluralité de trous (51), avec des jeux desdits trous communiquant avec une portion de canal de renvoi, et l'autre desdits trous (51) communiquant avec une portion de canal d'alimentation, lesdits canaux de renvoi et d'alimentation re-communiquant directement dans lesdits surmontoirs de renvoi et d'alimentation (R, S), respectivement.

8. Réseau de composants électroniques comprenait
une pluralité de composants électroniques ; et
un paquet refroidisseur de fluide tel que précisé dans une quelconque revendication précédente, chaque circuit de refroidissement individuel délivrant un fluide de refroidissement à un composant associé de ladite pluralité de composants électroniques.
